# EUROPEAN PATENT SPECIFICATION

(11) **EP 0 386 211 B1**
(45) Date of publication and mention of the grant of the patent: **23.03.1994**
(21) Application number: 89909984.0
(22) Date of filing: 14.08.1989
(51) Int. Cl.: H01L 31/0216, H01L 27/148

(54) **IMAGE SENSING DEVICE WITH REDUCED SMEAR**
BILDWANDLER MIT REDUZIERTEM SCHMIEREFFEKT
DETECTEUR D'IMAGES A MACULAGE REDUIT

(30) Priority: 25.08.1988 US 236413
(43) Date of publication of application: 12.09.1990
(73) Proprietor: EASTMAN KODAK COMPANY, Rochester, New York 14650-2201 (US)
(72) Inventor: LOSEE, David, Lawrence, Fairport, NY 14450 (US); MEHRA, Madhav, Rochester, NY 14618 (US)
(74) Representative: Buff, Michel
(86) International application number: US8903449
(87) International publication number: WO9002418

(56) References cited:
- EP-A- 0 108 480
- EP-A- 0 242 663
- IEEE Transactions on Electron Devices, vol. ED-34, no. 5, May 1987 (New York, US) ; N. Teranishi et al. : "Smear reduction in the interline CCD image sensor", pages 1052-1056.
- IEEE Transactions on Electron Devices, vol. ED-32, no. 8, August 1985, (New York, US) ; E. Oda et al. : "A CCD image sensor with 768x490 pixels", pages 1457-1461.
- Patent Abstracts of Japan, vol. 10, no. 175, (E-413)(2231), 20 June 1986 ; & JP-A-6124273
- Patent Abstracts of Japan, vol. 10, no. 359 (E-460)(2417), 3 December 1986 ; & JP-A-61158169
- Patent Abstracts of Japan, vol. 5, no. 19 (E-44)(691), 4 February 1981 ; & JP-A-55146967

## Description

### Technical Field:

This invention relates to image sensing devices and, more particularly, to image sensing devices which collect photogenerated charge.

### Background Art:

In interline transfer type imaging devices, photogenerated charge is collected on a pn junction or under the gate of a photocapacitor for a period of time and then transferred into a charge coupled register to be detected by an output circuit. During the time required for the read-out operation, light is still incident on the photodiode or photocapacitor, and photogenerated charge is being collected and stored for the following frame. In this mode of operation, it is necessary to shield the shift registers and transfer gate regions from exposure to the incident light. Such exposure will produce spurious signals in the detected image, thus degrading the performance of the device. This unwanted exposure has been called "image smear" in the literature.

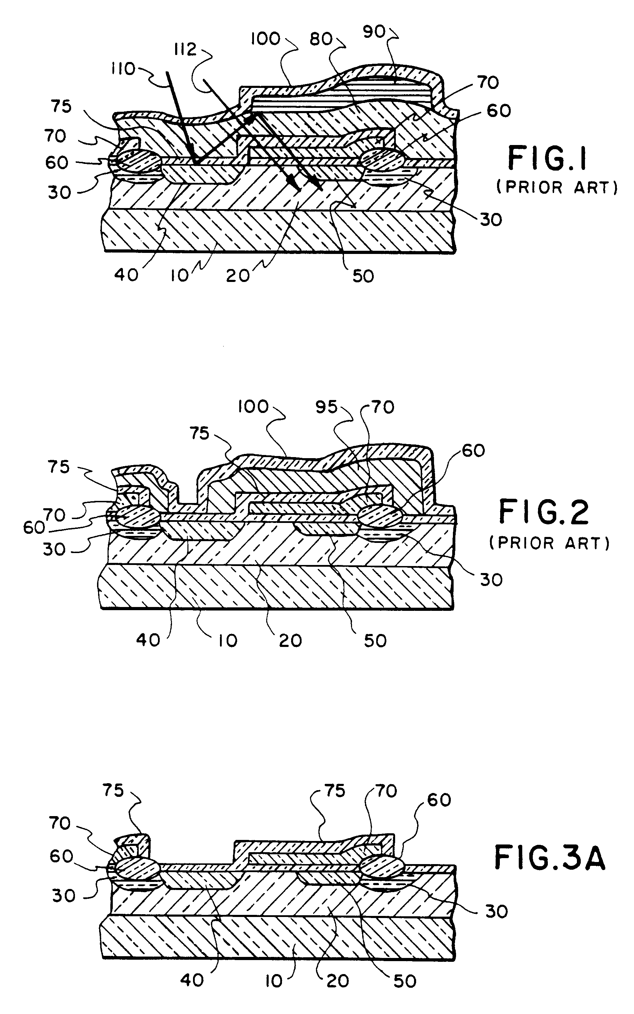

A variety of causes for image smear have been discussed and reviewed in a recent paper by Teranishi and Ishihara, IEEE Transactions on Electron Devices, ED-34, no 5, (1987), pages 1052-1056. A significant cause of smear identified by these authors is due to a waveguide effect which occurs between the light shield layer of the device and the underlying polysilicon CCD gates. This effect is illustrated in Fig. 1.

In Fig. 1, a semiconductor substrate 10 of first conductivity type, typically n, contains a doped region 20 of a second, opposite, conductivity type, typically p, a barrier region 30 consisting of higher doping second type conductivity and thick insulator 60, a photodiode region 40 of first conductivity type, a transfer channel region 50 of first conductivity type, a charge transfer gate 70, an insulating layer 75 over both the transfer gate and the photodiode, a smoothing layer of insulator 80, opaque light shield layer 90 and a top protective insulator layer 100. Incident light rays 110 and 112, illustrated schematically, are able to penetrate into the transfer channel region of the device where electron-hole pairs may be produced. Charges so produced may be collected in the transfer channel 50 and read out along with the desired photogenerated charge which has been collected by the photodiode 40. This charge is unwanted and produces smear.

As Teranishi and Ishihara have noted, it is desirable to have thinner insulating layers between the light shield and the underlying semiconductor device in order to minimize the effects of light rays such as 110 and 112. Typically, a layer of phosphosilicate glass is used for this insulator, and the light shield is aluminum. Teranishi and Ishihara minimized the insulator thickness by only using a thermally grown oxide layer for the insulator. This is illustrated in Fig. 2 where an aluminum light shield 95 is separated from the gate electrode and photodiode by thermally grown oxide 75. But, as is evident from their paper, the aluminum light shield 95 was subject to hillock growth, and the final structure had severe topographic features.

In image sensors for detecting color, however, a color filter pattern must still be fabricated. The structure of Fig. 1, due to the topography of the surface, is not well suited for color filter application, and additional smoothing layers must be applied before applying the color filter array. Such smoothing layers are typically rather thick layers of spun-on organic materials which can present manufacturing problems due the thickness required, and can add to image smear and "color cross-talk" as described by McColgin and Pace, U.S. Patent 4,553,153. The Fig. 2 surface has even more severe topographical features than the Fig. 1 structure.

### Disclosure of the Invention:

The present invention disclosure solves both of these problems, namely, the light leakage induced image smear and the surface topography of the image sensor. In this invention, a refractory material is used as the light shielding layer, and this material may be covered by a doped oxide layer. Due to the refractory properties of the light shield, the doped oxide layer may be heated to a temperature which causes this layer to flow and, hence, to produce a smooth surface which is more suitable for uniform application of subsequent layers, such as color filters.

More specifically, a thin insulating layer is provided over the photoreceptor sites and the transfer gates. A thin, opaque layer of refractory material, is deposited on the thin insulating layer and then patterned to form openings, which permits light to fall on the photoreceptor sites, and an additional coating of an insulating material then is provided which, when subject to elevated temperatures, can be caused to flow, thus producing a smoothed surface. A color filter pattern can readily be formed on this smooth surface.

A refractory material is used for the light shield because it permits use of chemical vapor deposited oxides and heat treatment to cause flow of such oxides. The image sensor according to the invention is featured in claim 1.

### Brief Description of the Drawings:

Fig. 1 is a fragmentary, partially schematic vertical section view through a semiconductor device, illustrating a prior art construction;
Fig. 2 is a fragmentary, partially schematic vertical section view through a semiconductor device, illustrating a prior art construction;
Figs. 3a-c are fragmentary, partially schematic vertical section views through a semiconductor device, illustrating various steps in the process of making a device in accordance with the present invention;
Fig. 4 is a fragmentary, partially schematic vertical section view through a semiconducor device, illustrating an alternative embodiment of the present invention;
Fig. 5 is a fragmentary, partially schematic vertical section view through a semiconducor device, illustrating another alternative embodiment of the present invention; and
Fig. 6 is a fragmentary, partially schematic vertical section view through another interline transfer charge coupled imaging device fabricated according to this invention.

It will be appreciated that for purposes of exposition, the dimensions are not to scale, since the various dimensions, particularly in the vertical direction, are quite small.

### Modes of Carrying Out the Invention:

A semiconductor substrate is provided with a plurality of light sensing elements and charge transfer means as illustrated in Fig. 3a. This is similar to the arrangement in Figs. 1 and 2 and need not be discussed further. Where elements correspond with Figs. 1 and 2, the same numbers will be used. A thin, opaque coating of a refractory material 72 is deposited and patterned to form openings for light rays using standard photomasking and etching techniques.

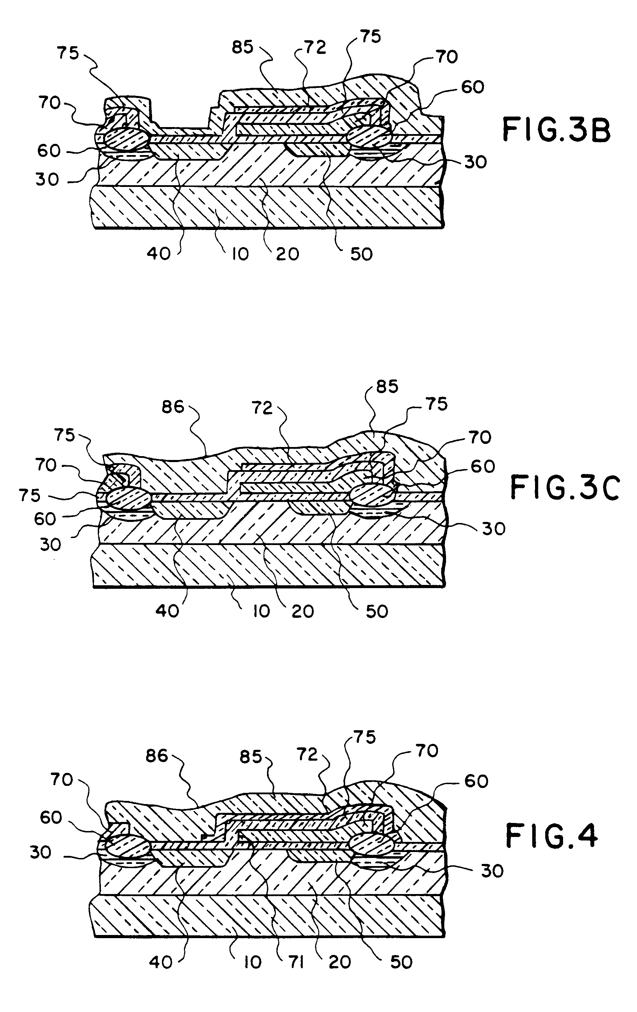

Such an opaque refractory light shield may consist of material selected from the group consisting of WSiₓ, MoSiₓ, TaSiₓ, TiSiₓ, W, Mo, or Ta, where x is a number between 2 and 4. The device is then coated with an insulating layer 85 which, when subject to high temperatures, will flow to form a smoother surface 86 as in Fig. 3c. This insulating layer 85 is made of glass that flows in response to elevated temperatures, such as to a doped oxide such as boro phosphosilicate glass where boron and phosphorous weight percentages are in the range of 3 to 7 percent.

Other such layers may be phosphosilicate glass with weight percent phosphorous in the range of 4 to 10 percent.

In Fig. 3b we see that the surface of layer 85 has severe topographical features. The surface 86 of Fig. 3c is quite smooth and facilitates the fabrication of color filter arrays.

An alternative patterning of the layer 72 is illustrated in Fig. 4 where the end regions 71 of the transfer gate is covered, and the thicker insulating region 60 may also be covered.

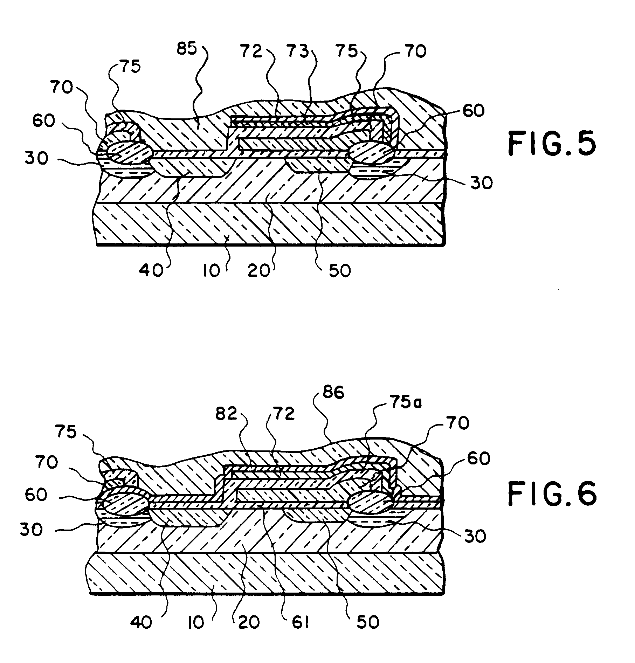

An additional layer in the light shield material may be incorporated as shown in Fig. 5 where the added layer 73 may be polysilicon. It may be desirable to incorporate such an additional layer in order to improve adhesion of the opaque material 72 or to provide a stress relief layer between layer 72 and the substrate. Subsequently, a color filter array can be applied according to procedures described by the Pace et al published European Application No. EP-A-0 249 991.

Turning now to Fig. 6, we see a structure similar to Fig. 3B. In Fig. 6, however, a glass layer 82 is deposited prior to glass layer 85.

Such glass layer may be pure SiO₂ and may serve to protect the underlying layers from adverse interaction with the dopants contained in glass layer 85.

### Example:

The following description gives an example of a device which was made and is illustrated in Fig. 6:
An n-type semiconductor 10 doped to approximately 30 ohm-cm resistivity was provided with a p-type region 20 by implantation of boron atoms with a dose of 1.0E+12 cm⁻² and diffused to a depth of thickness t1, approximately 3.5 µm. Channel stop barrier regions were formed by implantation of boron into region 30 with a dose of 1.0E+13 cm⁻², and subsequently growing an oxide 60 (SᵢO₂) of a thickness approximately 400 nm. An additional oxidation and subsequent etch-back reduced oxide 60 to a thickness of approximately 250 nm. A transfer channel region 50 was formed by ion implantation of phosphorus atoms, with a total dose 3.25E+12 cm⁻², and transfer gate oxide 61, approximately 50 nm thick, grown in the charge transfer region and over the photodiode region. A polysilicon electrode 70 then was formed according to procedures described by Losee et al, in U.S. Patent 4,613,402, and phosphorus was implanted into the photodiode region with a dose of 7.0E+12 cm⁻². A thin oxide layer 75 was grown at a temperature of 950°C, in a wet ambient, for approximately 8 minutes, and a layer 72 of approximate composition WSi and thickness approximately 300 nm deposited by sputtering. Insulating glass layer 82 was deposited by chemical vapor deposition, consisting of approximately 100 nm undoped oxide covered by 500 nm of oxide doped with approximately 4 wt% boron and 4 wt% phosphorus. The device was subsequently annealed in an inert ambient for 30 minutes at a temperature of 1000°C.

### Industrial Applicability:

The invention is advantageously employed in area image sensors which use photodiodes.

## Claims

1. Image sensor device having a plurality of photodiodes (40) for storing charge in response to actinic light, charge transfer devices (50) for receiving the stored charge from different ones of the photodiodes, gate means (70) disposed over the charge transfer devices and effective in a first condition for causing charge to transfer from the photodiodes and in a second condition for transferring charge along the transfer devices, and a thin oxide layer (75) being disposed over the photodiode and the gate means, characterized by :
a) an opaque refractory light shield (72) provided on the oxide layer over the gate means and formed of a material selected from the group consisting of WSiₓ, MoSiₓ, TaSiₓ, TiSiₓ, W, Mo, or Ta, where x is a number between 2 and 4 and ;
b) a flowed glass layer (85) disposed over the thin oxide over the photodiodes and the opaque refractory light shield providing a smooth surface suitable for subsequent fabrication of a color filter array.

2. A device as in claim 1, where the refractory opaque light shield is composed of multiple layers of material, all of which are refractory and at least one of which is opaque.

3. A device as in claim 1, where an additional layer of polysilicon (73) covers the opaque refractory light shield (72).

4. A device as in claim 3 where the overlying layer is borophosphosilicate glass.

5. The image sensor device of claim 1 wherein the gate means includes a polysilicon layer (70) having a given thickness and wherein the refractory light shield (72) is disposed to intercept light which would pass through the end wall (71) of the polysilicon gate and causing electron-hole pairs to be formed in the charge transfer device, thereby minimizing smear.

## Patentansprüche

1. Bildsensor mit einer Vielzahl von Fotodioden (40) zur Ladungsspeicherung in Abhängigkeit von aktinischem Licht, Ladungsübertragungseinrichtungen (50) zum Aufnehmen der von einzelnen der Fotodioden gespeicherten Ladung, Gatter (70), die auf den Ladungsübertragungseinrichtungen angeordnet sind und bewirken, daß in ihrem einen Zustand Ladung von den Fotodioden übernommen und im anderen Zustand Ladung über die Übertragungseinrichtungen übertragen wird, sowie einer dünnen, über der Fotodiode und dem Gatter angeordneten Oxidschicht (75), gekennzeichnet durch
a) eine lichtundurchlässige, hitzebeständige Lichtabschirmung (72), die auf der über dem Gatter befindlichen Oxidschicht vorgesehen und aus einem Material gebildet ist, das aus der Gruppe bestehend aus WSiₓ, MoSiₓ, TaSiₓ, TiSiₓ, W, Mo oder Ta ausgewählt wurde, wobei x eine Zahl zwischen 2 und 4 darstellt;
b) eine über der dünnen Oxidschicht, den Fotodioden und der lichtundurchlässigen Lichtabschirmung angeordnete Aufschmelzglasschicht, die eine für die nachfolgende Herstellung einer Farbfiltermatrix geeignete glatte Oberfläche besitzt.

2. Bildsensor nach Anspruch 1, dadurch gekennzeichnet, daß die hitzebeständige, lichtundurchlässige Lichtabschirmung aus mehreren Materialschichten besteht, die sämtlich hitzebeständig sind und wovon mindestens eine Schicht lichtundurchlässig ist.

3. Bildsensor nach Anspruch 1, dadurch gekennzeichnet, daß die hitzebeständige, lichtundurchlässige Lichtabschirmung (72) von einer weiteren Schicht aus Polysilicium (73) bedeckt ist.

4. Bildsensor nach Anspruch 3, dadurch gekennzeichnet, daß die oberste Schicht aus Borphosphorsilikatglas besteht.

5. Bildsensor nach Anspruch 1, dadurch gekennzeichnet, daß die Gatter eine Polysiliciumschicht (73) mit vorgegebener Dicke aufweisen und daS die hitzebeständige Lichtabschirmung (72) Licht abfängt, das ansonsten durch die Stirnwand (71) des Polysiliciumgatters hindurchtreten und bewirken wurde, daß sich in der Ladungsübertragungsvorrichtung Elektronen-Löcher-Paare bildeten, die zu unerwünschten Nachleuchteffekten führten.

## Revendications

1. Dispositif de détection d'image comportant une pluralité de photodiodes (40) pour emmagasiner une charge en réponse à une lumière actinique, des dispositifs de transfert de charge (50) pour recevoir la charge emmagasinée provenant de différentes photodiodes parmi les photodiodes, des moyens de porte (70) disposés sur les dispositifs de transfert de charge et efficaces dans une première condition pour entraîner la charge à se transférer à partir des photodiodes et dans une seconde condition pour transférer la charge suivant les dispositifs de transfert, et une mince couche d'oxyde (75) étant disposée sur la photodiode et sur les moyens de porte, caractérisé par :
a) un écran à la lumière (72), réfractaire et opaque placé sur la couche d'oxyde au-dessus du moyen de porte et formé d'un matériau sélectionné dans le groupe qui est constitué de WSiₓ, MoSiₓ, TaSiₓ, TiSiₓ, W, Mo ou Ta, où x est un nombre situé entre 2 et 4, et
b) une couche de verre ayant coulé (85) disposée sur la mince couche d'oxyde au-dessus des photodiodes et de l'écran à la lumière, réfractaire et opaque procurant une surface lisse appropriée pour la fabrication ultérieure d'un réseau de filtre couleur.

2. Dispositif selon la revendication 1, où l'écran à la lumière opaque et réfractaire est constitué de multiples couches de matériau, la totalité de celles-ci sont réfractaires et au moins une de celles-ci est opaque.

3. Dispositif selon la revendication 1, où une couche supplémentaire de polysilicium (73) recouvre l'écran à la lumière réfractaire et opaque (72).

4. Dispositif selon la revendication 3, où la couche se trouvant au-dessus est du verre borophosphosilicate.

5. Dispositif détecteur d'image selon la revendication 1, dans lequel le moyen de porte comporte une couche de polysilicium (70) ayant une épaisseur donnée et dans lequel l'écran à la lumière réfractaire (72) est disposé pour intercepter la lumière qui devrait passer à travers la paroi d'extrémité (71) de la porte de polysilicium et entraîner des paires électrons-trous à être formées dans le dispositif de transfert de charge, minimisant de ce fait la marbrure.
